# EUROPEAN PATENT APPLICATION

(11) **EP 4 579 948 A1**
(43) Date of publication of application: **02.07.2025**
(21) Application number: 24213569.7
(22) Date of filing: 18.11.2024
(51) Int. Cl.: H01Q 1/22, H01L 23/538

(54) **WIDEBAND ANTENNAS FOR WIRELESS BROADCAST CHANNELS EMPLOYED BETWEEN CHIPLET, DIE, PACKAGE, OR PRINTED-CIRCUIT BOARDS**

(30) Priority: 28.12.2023 US 202318398261
(71) Applicant: INTEL Corporation, Santa Clara, CA 95054 (US)
(72) Inventor: YANG, Tae Young, Portland, 97229 (US); ACIKALIN, Tolga, San Jose (US); YAMADA, Shuhei, Vancouver, 98684 (US); ABDULLA, Mostafa, Rancho Cordova, 95742 (US); FOUST, Kenneth, Beaverton, 97007 (US); PELLERANO, Stefano, Beaverton, 97007 (US); ZHOU, Zhen, Chandler, 85248 (US)
(74) Representative: Viering, Jentschura & Partner mbB Patent- und Rechtsanwälte

(57) **Abstract**

A device may include a plurality of carriers, wherein each carrier includes a plurality of communication processors, each communication processor disposed over or in a respective carrier of the plurality of carriers and configured to provide a wireless broadcasting communication channel, and a plurality of antennas, each antenna disposed on or in a respective carrier and coupled to a respective communication processor, wherein each antenna extends into a corner of the respective carrier, and wherein the antennas of each pair of adjacent carriers are positioned at a distance from each other at less than about 1 wavelength corresponding to the lowest operating frequency.

## Description

### Technical Field

Various aspects of this disclosure generally relate to devices including a plurality of carriers configured to wirelessly communicate with each other. By way of example, various aspects relate to chiplets and Printed Circuit Boards, PCBs, wirelessly communicating with each other.

### Background

In order to improve yield and reduce design cost in semiconductor fabrication and packaging, a multi-carrier (chiplet) architecture and modular design are often used nowadays. However, communication between the carriers through wire-based Network-on-package, NoP, introduces a relatively high latency, since data movement is not as fast between carriers as inside a monolithic die. For example, core-to-core communication latency between cores on the same die may be around 20 ns, and around 140 ns when the cores are on different dies/chiplets. Furthermore, using current state-of-the-art wireless broadcasting communication between carriers suffers from several drawbacks and pratical limitations, in particular when the carriers are close to each other, for example at less than about 1 wavelength corresponding to the lowest operating frequency.

Additionally, cache write-update protocols, i.e. the broadcasting of changes to the caches shared between multiple carriers may utilize significantly more interconnect bandwidth to eliminate coherence misses from the system. As an example, the average contribution of broadcasting traffic using multiple carriers in Convolutional Neural Networks, CNN, -based deep learning may be responsible for 80% or more of the total inference energy and latency of the system, i.e. only 20% or less may be used for the actual computation performed by the CNN.

It is predicted that in the future bandwidth density of interconnects may double or triple every two years, creating an equivalent of Moore's Law for on-package interconnects, thus making it difficult to scale multi-carrier/chiplet-based hardware accelerators towards High Performance Computing, HPC.

### Brief Description of the Drawings

In the drawings, like reference characters generally refer to the same parts throughout the different views. The drawings are not necessarily to scale, emphasis instead generally being placed upon illustrating the principles of the invention. It should be understood that the drawings are diagrammatic and schematic representations of exemplary aspects of the invention, and are neither limitative nor necessarily drawn to scale of the present invention. In the following description, various embodiments of the invention are described with reference to the following drawings, in which:
FIG. 1 shows wireless chip-to-chip broadcasting between adjacent dies;
FIG. 2 shows an exemplary carrier according to some aspects;
FIG. 3 shows an exemplary 2x2x3 chiplet structure according to some aspects;
FIG. 4 shows the layers of an exemplary chiplet according to some aspects;
FIG. 5 shows a cross-sectional view of the layers of an exemplary chiplet according to some aspects;
FIG. 6 shows channel performance for the top chiplet floor;
FIG. 7 shows channel performance for the middle chiplet floor;
FIG. 8 shows an exemplary arrangement of adjacent PCBs according to some aspects;
FIG. 9 shows an exemplary device according to some aspects;

### Description

The following detailed description refers to the accompanying drawings that show, by way of illustration, specific details and embodiments in which the invention may be practiced.

The word "exemplary" is used herein to mean "serving as an example, instance, or illustration". Any embodiment or design described herein as "exemplary" is not necessarily to be construed as preferred or advantageous over other embodiments or designs.

The word "over" used with regards to a deposited material formed "over" a side or surface, may be used herein to mean that the deposited material may be formed "directly on", e.g. in direct contact with, the implied side or surface. The word "over" used with regards to a deposited material formed "over" a side or surface, may be used herein to mean that the deposited material may be formed "indirectly on" the implied side or surface with one or more additional layers being arranged between the implied side or surface and the deposited material.

The terms "at least one" and "one or more" may be understood to include a numerical quantity greater than or equal to one (e.g., one, two, three, four, [...], etc.). The term "a plurality" may be understood to include a numerical quantity greater than or equal to two (e.g., two, three, four, five, [...], etc.).

The words "plural", "plurality" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. The phrases "group (of)", "set (of)", "collection (of)", "series (of)", "sequence (of)", "grouping (of)", etc., and the like in the description and in the claims, if any, refer to a quantity equal to or greater than one, i.e., one or more. The phrases "proper subset", "adjust subset", and "lesser subset" refer to a subset of a set that is not equal to the set, illustratively, referring to a subset of a set that contains less elements than the set.

The phrase "at least one of' with regard to a group of elements may be used herein to mean at least one element from the group including the elements. For example, the phrase "at least one of' with regard to a group of elements may be used herein to mean a selection of: one of the listed elements, a plurality of one of the listed elements, a plurality of individual listed elements, or a plurality of a multiple of individual listed elements.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit, and may also be referred to as a "processing circuit," "processing circuitry," among others. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality, among others, and conversely that any single processor, controller, or logic circuit detailed herein may be realized as two (or more) separate entities with equivalent functionality, among others.

Wired communication between carriers, such as e.g. between adjacent chiplets or PCBs, greatly increases latency when compared to communication performed on a single carrier/die.

A possible solution to reduce the latency occurring during inter-carrier communication is the use of antennas or couplers to wirelessly communicate between the carriers.

However, previously used and/or conceptualized broadcasting antennas for wireless-enabled-on-chip, NoC, or network-on-package, NoP, communication have limited practical usage, in particular when the carriers are in close range of each other (e.g. at less than about 1 wavelength corresponding to the lowest operating frequency from each other).

Various examples of previous broadcasting antennas include variations of commonly used antennas, such as for example a simple zig-zag, resonant antenna, electric and magnetic dipoles, and Through-Silicon Via, TSV, antennas.

For example, using TSV broadcasting antennas using silicon as broadcasting channel medium only provides limited practical use.

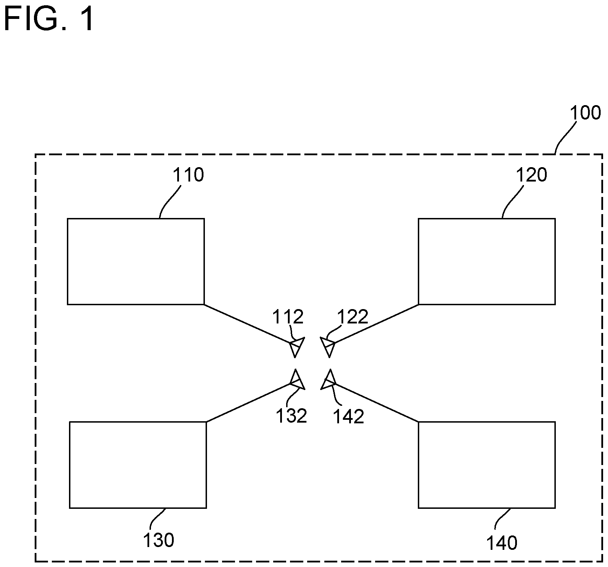

**FIG.** 1 illustrates wireless chip-to-chip broadcasting between adjacent dies 110, 120, 130 and 140 using antennas 112, 124, 132 and 142, wherein each antenna has a top-loaded monopole.

In FIG. 1, the antennas 112, 122, 132 and 142 may be positioned/arranged on an underlying package 100 (or a base die). The package 100 may include a plurality of dies 110, 120, 130 and 140.

Alternatively, the antennas 112, 122, 132, 142 may be arranged on a bridge die positioned between the four adjacent dies 110, 120, 130, 140 (not shown in FIG. 1). The bridge die may further be a mixed die and include transmission lines (not shown in FIG. 1).

The structure illustrated in FIG. 1 may help in reducing latency and/or traffic congestion over NoP when the dies/carriers are separated by a "relatively long" distance (e.g. at least 2 wavelengths, which is about 5.5 mm at 110 GHz) from each other. However, the localized wireless broadcasting structure may suffer from overhead and latency increase when a tightly-integrated (e.g. distance of less than about 1 wavelength corresponding to the lowest operating frequency between carriers) multi-carrier architecture is used.

There is therefore a need to provide a simple and cost-efficient wireless network for communication between a plurality of adjacent carriers.

By way of example, there is a need to improve broadcasting capability of wireless-enabled NoP, and to improve the design of the broadcasting antennas in order to reduce (interconnect) latency while ensuring good broadcasting channel quality, e.g. when the carriers are very close to each other (e.g. less than about 1 wavelength corresponding to the lowest operating frequency).

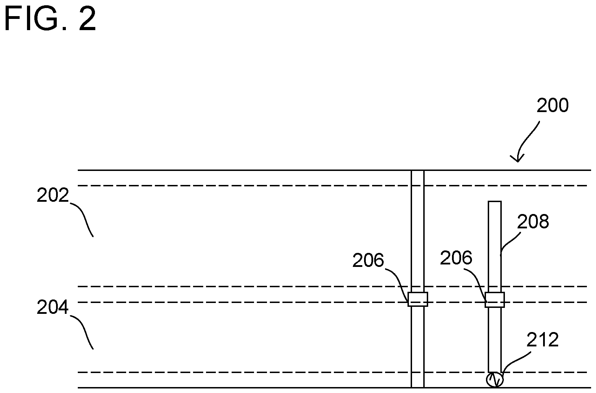

FIG. 2 illustrates an exemplary carrier 200 according to some aspects. Carrier 200 includes a first substrate layer 202, a second substrate layer 204, bonding 206, a driven blind via 208, a reflector through via 210, and a (AC) voltage source 212, wherein the antenna comprises the driven blind via 208 and the reflector through via 210. The voltage source 212 is positioned between the antenna feed and the ground.

As can be seen in FIG. 2, the antenna, comprising driven blind via 208 and reflector through via 210, is formed in a non-monolithic die.

The carrier 200 may further include a communication chip/processor 214 (not shown in FIG. 2) providing a wireless communication channel, and antenna, comprising driven blind via 208 and reflector through via 210, may be coupled to the communication chip 210 (and/or may be included in communication chip 210).

Alternatively, the antenna (feed) may be formed only on the upper substrate layer 202.

In the following, embodiments and aspects of the invention are described in which the adjacent carriers are adjacent stacked chiplets arranged on a die. It is understood that is merely demonstrative in nature, and that the disclosed embodiments and aspects are applicable to other types of carriers.

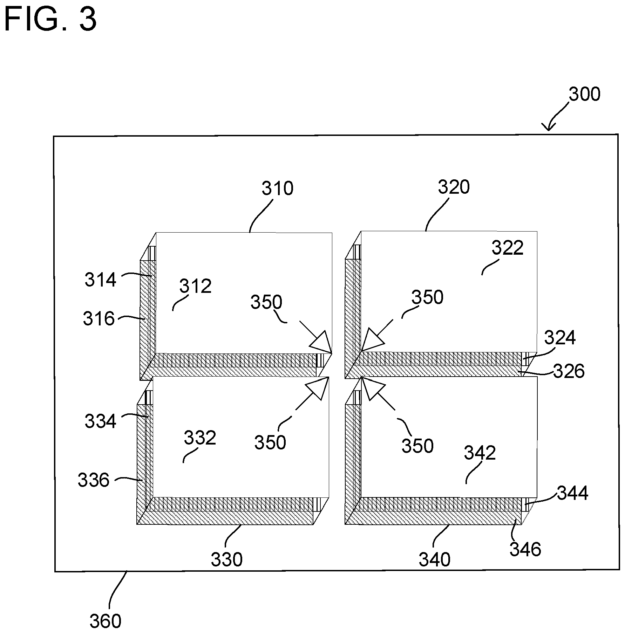

**FIG.** 3 illustrates an exemplary 2x2x3 chiplet structure 300 in a non-monolithic die, wherein the chiplet structure 300 includes four adjacent vertically stacked chiplet stacks 310, 320, 330, 340, wherein each chiplet stack includes three chiplets positioned on package (die) 360. Each chiplet further includes an antenna 350 in a corner of the chiplet, enabling wireless NoP broadcasting. As shown in FIG. 3, the chiplets are arranged in such a way on package 360 that their respective corners including the antennas 350 face each other, i.e. are in close proximity of one another.

The chiplet stacks may be positioned on an interposer or on an Embedded Multi-Die Interconnect Bridge, EMIB on an organic package (not shown in FIG. 3).

Chiplets on the same level, such as for example chiplets 312, 322, 332 and 342 are able to wirelessly communicate with each other.

Each chiplet of each chiplet stack (chiplets 312, 314, 316, 322, 324, 326, 332, 334, 336, 342, 344 and 346) may further include a communication processor and an antenna (not shown in FIG. 3).

Alternatively, only chiplets on one level may include an antenna 350 and a communication processor. For example, only chiplets 312, 322, 332 and 342 (the chiplets on top of each respective chiplet stack) may include an antenna 350 and a communication processor.

The antennas 350 may be formed in the same way as antenna, comprising driven blind via 208 and reflector through via 210, in a non-monolithic die complex, and are unique vertically-polarized antennas integrated in the chiplet. As can be seen in FIG. 3, the antennas 350 are of an archer bow and arrow type/shape, and are positioned in the corner of the chiplet such that they point in the corner direction and in the direction of the corner of an opposite chiplet.

The antennas 350 are extremely-wideband, EWB, antennas with a large operational bandwidth of over 50 GHz (operating between 100 GHz and 200 GHz), and further provide a channel with low group delay variation.

The antennas 350 thus do not suffer from the typcial problems of narrow operational bandwidth and limited angular coverage of wireless broadcasting antennas in tightly-integrated multi-chiplet architectures.

Furthermore, the provided wireless broadcasting channels can support both air and immersion/liquid cooling systems.

The exemplary arrangment illustrated by FIG. 3 reduces interconnect latency, as well as bandwith and energy required for the communication between adjacent chiplets, and further enables a scalable 3D heterogeneous chiplet integration.

The arrangement of FIG. 3 therefore reduces latency, bandwith and energy consumption in hardware accelerators. For example, it reduces latency and energy required for communication between adjacent chiplets in CNN-based deep learning tasks, thus accelerating these type of tasks.

The arrangement of FIG. 3 further reduces wire routing congestion and additional insertion loss, and also reduces the number of bumps and package balls, potentially reducing package size.

By reducing the number of vertical and horizontal interconnects needed to connect the chiplets vertically and horizontally, the freed-up space can be reused for other tasks, such as power delivery, more space circuits, etc.

Therefore, the arrangement of FIG. 3 allows for high data-throughput, control and cache messaging across adjacent chiplets on the same level/floor.

In the following, the antenna and chiplet design and geometry are discussed in detail. It is appreciated that the following devices and implementations are exemplary and demonstrative in nature.

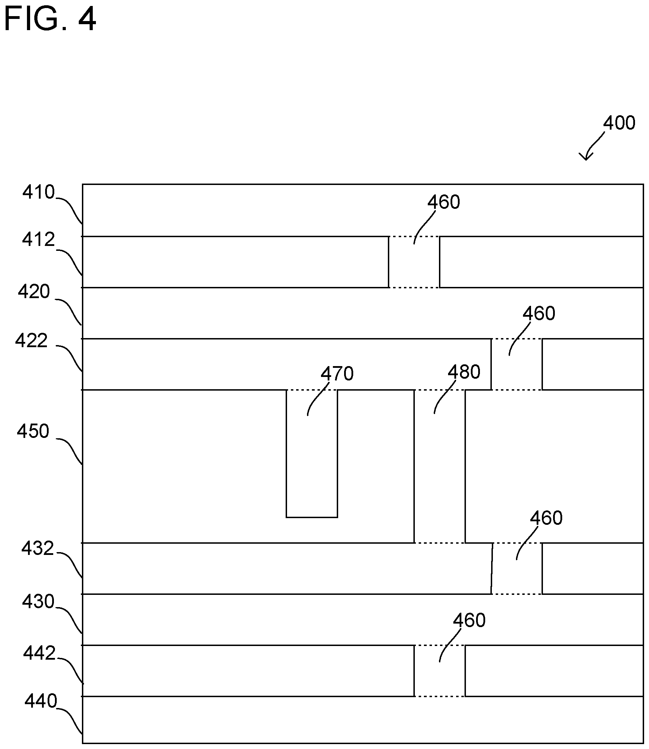

**FIG. 4** illustrates the layers of an exemplary chiplet 400 according to some aspects.

In general, chiplet 400 may be part of a 2x2xN 3D chiplet array, however for simplicity it is assumed in the following that chiplet 400 is part of a 2x2x3 3D chiplet array, wherein each vertically stacked chiplet stack includes three chiplets, i.e. it is assumed in the following that chiplet 400 is part of a chiplet array corresponding to the chiplet structure 300 illustrated in FIG. 3.

Chiplet 400 includes four outer ground metal layers 410, 420, 430 and 440 and a glass core 450. Each of the outer metal layers 410, 420, 430, 440 are e.g. made out of copper, Cu. Between the ground metal layers, the substrate (layers) 412, 422, 432, 442 are positioned. The substrate (layers) are e.g. made out of polyimide, PI. The outer layers are 2-layer redistribution layers, RDL, and can be used to stack up the chiplets, and/or form part of the antenna structure and/or route signals from each bump of chiplets. The glass core 450 has at least one blind glass via 470 and a Through-Glass Via, TGV, 480. The chiplet 400 further includes a plurality of vias 460 in the substrate (layers) 412, 422, 432, 442.

Chiplet 400 is not necessarily a symmetric stack-up as shown in FIG. 4, but can alternatively also be asymmetric, e.g. having only a top (bottom) metal layer and two bottom (top) outer layers, each outer layer having a substrate and metal layer.

Furthermore, the core of chiplet 400 is not necessarily a glass core, but be made out of other materials, such as e.g. silicon or organic substrates.

By way of example, chiplet 400 is designed for glass-based D-band broadcasting channels operating from 110 to 170 GHz.

The blind glass via 470 and the TGV(s) 480 are used to construct the antenna, such as e.g. antenna 350, and a surrounding reflector. The driven blind glass via 470 forms the main radiation part of the antenna. Using a blind glass via as part of the antenna structure to enable wireless broadcasting between neighboring chiplets is not possible in wired interconnect applications, since it would result in a signal disconnection.

Using a blind glass via as part of the antenna structure simplifies the antenna geometry by reducing the number of redistribution layers occupied by the antenna, thus also reducing the cost. A plurality of blind glass vias (not shown in FIG. 4) of varying lengths in a single (thick) glass core is able to mimic a multi-layer glass substrate.

Each of the outer metal layers 410, 420, 430, 440 may for example have a thickness of 4µm, and the substrate layers may for example each have a thickness of 4µm. The glass core 450 may for example have a thickness of 150 µm and a 7.7 dielectric constant. The height of a vertically stacked chiplet stack including three chiplets 400 may therefore be around 550 µm. The width of chiplet 400 may be around 2mm.

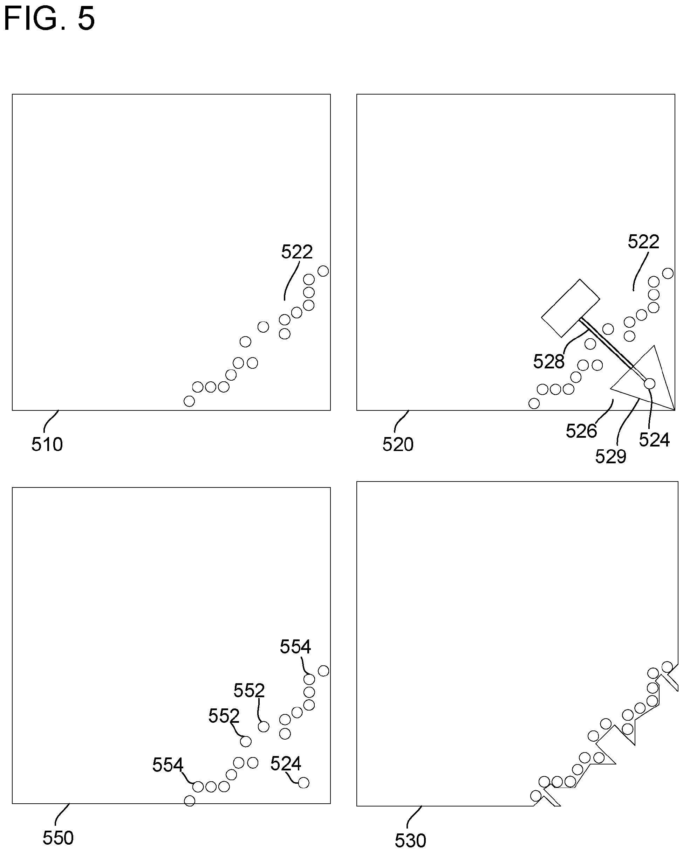

FIG. 5 shows a horizontal cross-sectional view of the layers of chiplet 400 according to some aspects. FIG. 5 shows a cross-sectional view of a first outer ground layer 510 (corresponding to layer 410 of FIG. 4), a cross-sectional view of a second outer ground layer 520 (corresponding to layer 420 of FIG. 4), a cross-sectional view of a core glass layer 550 (corresponding to glass core 450 of FIG. 4), and a cross-sectional view of third and fourth outer ground layers 530 (corresponding to layers 430 and 440 of FIG. 4).

As can be seen in FIG. 5, a series of (ground) TGVs 522 are formed on every layer for electrically shorting the ground layers, together with first and second layer vias 460, and third and fourth layer vias 460 (not shown in FIG. 5) . The series of TGVs 522 serve as a reflector, impedance transformer and for shaping of the near-field pattern of the coupler.

An antenna (structure) 526 is formed in all of the outer layers 510, 520, and 530. The antenna structure 526 is a 3D vertical aperture-shaped antenna excited by a blind ground via, and is outlined by all the TGVs through all four metal layers 410, 420, 430 and 440 (not shown in FIG. 5, the shape of the antenna is only outlined in layer 520). As shown in FIG. 5, the antenna 526 may have an "archery bow and arrow" shape. The main radiation structure for the antenna being the driven blind glass via 524.

The antenna 526 does not necessarily need to have the "arrow" shape illustrated in FIG. 5, and may have different shapes, which don't have to be symmetric.

The antenna 526 is fed by a co-planar waveguide, CPW, 528 transmission-line and connected to the driven blind glass via 524. The center signal line of the CPW 528 is connected a driven glass via pad that is connecting to the driven blind glass via 524. The end portion of the CPW 528 may be connected to RFIC through signal routing.

There is a triangular metallic void 529 around the driven blind glass via pad, which is located close to the tip of the corner. The void shape 529 prevents the driven blind glass via 524 from getting electrically shorted, and also controls the parasitic capacitance between the first layer 510 and the second layer 520.

The triangular void shape is an ideal (optimal) shape to bring the driven blind glass via 524 closer to the tip of the corner and to enable the wireless link response between a plurality of antennas 526 (positioned on adjacent chiplets 400) to achieve a low (minimum) channel loss.

The rectangular void shown on the second layer 520 of FIG. 5 is typically only for simulation purposes to excite the antenna, and not necessarily part of the antenna structure.

The geometric topology of antenna 526 can support various gap dielectric materials between the dies, chip(let)s, packages, PCBs, and/or mix of them. The supported materials include air, mold/ underfill materials, epoxy, silicon, glass and water.

As can be seen in the cross-sectional view of the glass core layer 550, the TGVs 522 are further divided into a first group of two ground TGVs 552 positioned behind a second group of driven TGVs 554. The ground TGVs 552 close to the co-planar waveguide, CPW, 528 transmission-line are mainly used for impedance matching, while TGVs 554 mainly contribute to shape the near-field pattern of the coupler.

The reflector TGV shape can be optimized through conventional optimization algorithms, such as for example the genetic algorithm, the particle swarm algorithm or the CMA evolution strategy.

The optimized reflector shape, together with the triangular metal void and the CPW feed is however always a variation of the bow-and-arrow shape to enable broadcasting the signal to other/adjacent chiplet stacks (for example the three adjacent chiplet stacks as illustrated in FIG. 3) with a relatively flat channel amplitude response.

Furthermore, the bow-shape reflector of the antenna is not necessarily symmetric or mirrored around the CPW feed as illustrated in FIG. 5 if the desired power delivery ratios are different between the adjacent chiplets receiving the broadcast signal.

As can be further seen in FIG. 5, the cut-out shape of the third and fourth outer layers 530 follows the bow shape of the reflector TGV closely. This achieves an extremely-wideband (ultra-wideband) operational frequency range for the antennas 526, as well as low channel loss and low group-delay variation.

The exemplary design illustrated by FIG. 5 is easily scalable to support 4-, 5-, 10-, ..., N-floor vertically-stacked chiplet stacks. Furthermore, the design can support other substrate materials, such as silicon and organic materials.

In the following, simulation results for the vertically stacked 2x2x3 3D chiplet stack/array of FIG. 3, 4 and 5 are described.

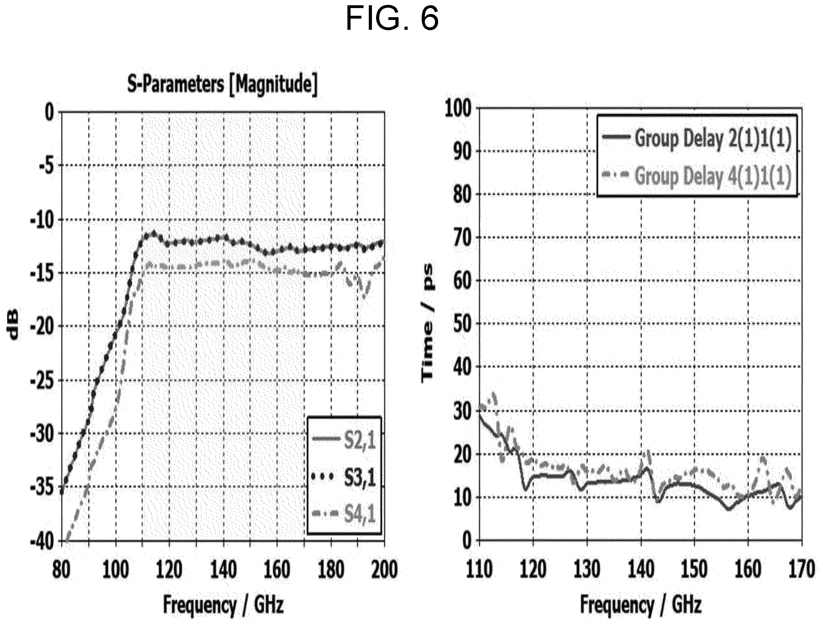

**FIG.** 6 illustrates the channel performance for the top chiplet floor when the antenna of the first chiplet stack 310 is excited. In the simulation results of FIG. 6, only the top floor (third floor) antenna of chiplet stack 310 is excited, antenna excitation ports on the other floors are terminated to a reference impedance (e.g. 25 Ohms).

Antenna port number 1 for the scattering-parameter curve legend as well as the group-delay curve legend in FIG. 6 is defined for the top floor 312 of the first chiplet stack 310 illustrated in FIG 3, antenna port number 2 is defined for the top floor 322 of the second chiplet stack 320, antenna port number 3 is defined for the top floor 332 of the third chiplet stack 330, and antenna port number 4 is defined for the top floor 342 of the fourth chiplet stack 340.

The scattering parameter S2,1 in FIG. 6 is evaluated from antenna port 1 to antenna port 2 (normalized power delivered from antenna port 1 to antenna port 2), the scattering parameter S3,1 in FIG. 6 is evaluated from antenna port 1 to antenna port 3 and the scattering parameter S4,1 in FIG. 6 is evaluated from antenna port 1 to antenna port 4.

"Group Delay 2,1" in FIG. 6 indicates the delay from antenna port 1 to antenna port 2 and "Group Delay 3,1" in FIG. 6 indicates the delay from antenna port 1 to antenna port 3. The additional "(1)" in "Group Delay" indicates that it is a first mode, i.e. a (fundamental) mode meeting (solving) Maxwell's equations and their boundary conditions.

As can be seen in FIG. 6, the top-floor simulation results shows over 60 GHz transmission bandwidth, less than 15 dB broadcasting channel loss in the target frequency range of 110 GHz to 170 GHz, and less than 25 ps group delay variation (second graph of FIG. 6).

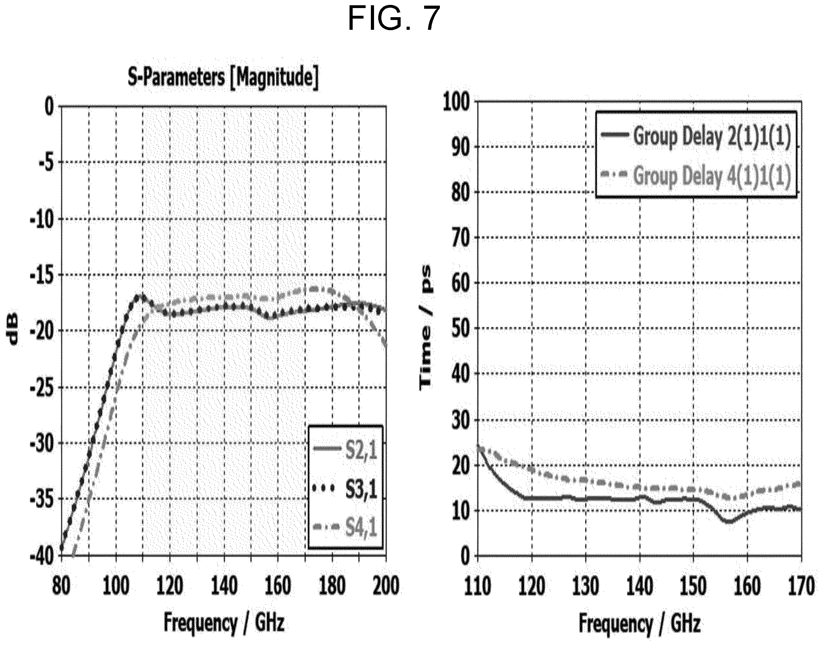

**FIG. 7** illustrates the channel performance for the middle chiplet floor when the antenna of the first chiplet stack 310 is excited. In the simulation results of FIG. 7, only the middle floor (second floor) antenna of chiplet stack 310 is excited, antenna excitation ports on the other floors are terminated to a reference impedance.

Antenna port number 1 for the scattering-parameter curve legend as well as the group-delay curve legend in FIG. 7 is defined for the middle floor (not shown) of the first chiplet stack 310 illustrated in FIG 3, antenna port number 2 is defined for the middle floor (not shown) of the second chiplet stack 320, antenna port number 3 is defined for the middle floor (not shown) of the third chiplet stack 330, and antenna port number 4 is defined for the middle floor (not shown) of the fourth chiplet stack 340.

Similarly to FIG. 6, the scattering parameter S2,1 in FIG. 7 is evaluated from antenna port 1 to antenna port 2, the scattering parameter S3,1 in FIG. 7 is evaluated from antenna port 1 to antenna port 3 and the scattering parameter S4,1 in FIG. 7 is evaluated from antenna port 1 to antenna port 4. Group delay 2,1 in FIG. 7 indicates the delay from antenna port 1 to antenna port 2, and Group delay 3,1 in FIG. 7 indicates the delay from antenna port 1 to antenna port 3.

The middle-floor simulation results of FIG. 7 show over 60 GHz transmission bandwidth, less than 20 dB broadcasting channel loss in the target frequency range of 110 GHz to 170 GHz, and less than 20 ps group delay variation (second graph).

As can be seen in FIG. 7, the group-delay response of the middle-floor broadcasting channel is relatively flat compared to the top-floor brodcasting case of FIG. 6.

This effect occurs because reflected electromagnetic waves from the top chiplet floor and bottom chiplet floor are "balanced" with opposite phases, i.e. at (close to) net zero status. However, some of the "balanced" electromagnetic fields are absorbed at the terminated ports of the top and bottom floors. Therefore, the broadcasting channel loss of the middle-floor case of FIG. 7 is higher than that of top-floor case of FIG. 6.

Furthermore, simulation results of the power-density flow at 140 GHz of the top floor chiplets when the antennas of the first top chiplet 312 is excited show a smooth power density transition at the impedance boundaries (not shown in FIG. 6 or FIG. 7). This implies relatively flat broadcasting link responses to the three adjacent chiplets 322, 332 and 342.

As a further embodiment, the package substrate may be a PCB, and wireless broadcasting may be between adjacent package or PCBs. In other words, the glass-based EWB vertically-polarized antenna described for chiplet stacks above may can also be applied to package-to-package wireless broadcasting channels between adjacent packages, or in a similar fashion can be implemented near the corner of PCBs to provide a broadcast channel between adjacent PCBs.

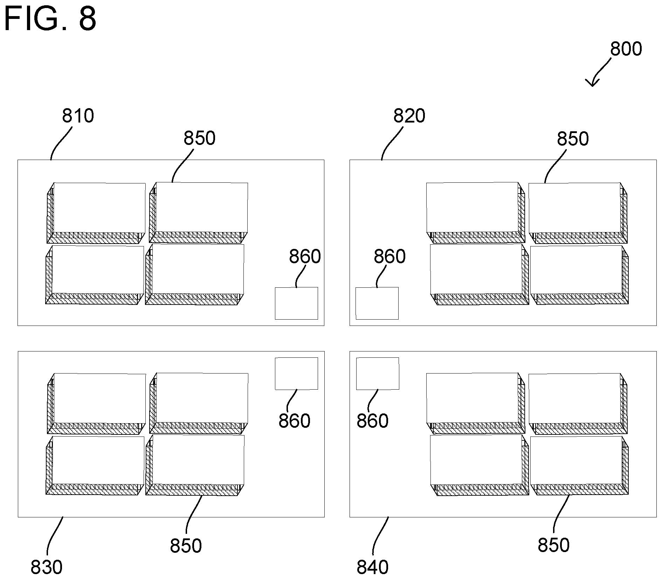

**FIG. 8** shows an exemplary arrangement 800 of adjacent PCBs 810, 820, 830 and 840, wherein each PCB includes a plurality of chiplet stacks 850, e.g. chiplets stacks such as the 2x2x3 3D chiplet stack of FIG. 3. Each PCB includes a further chiplet 860 that is attached to the PCB. Chiplet 860 functions as both an antenna and RFIC chiplet and is formed in a non-monolithic die complex using hybrid bonding, direct bonding, or other methods of bonding. In similar fashion, arrangement 800 can be of semiconductor packages, where the wireless broadcasting channel is implemented in between.

Alternatively, a separate antenna chiplet and separate RFIC chiplet may be used instead of a single chiplet 860 (not shown in FIG. 8).

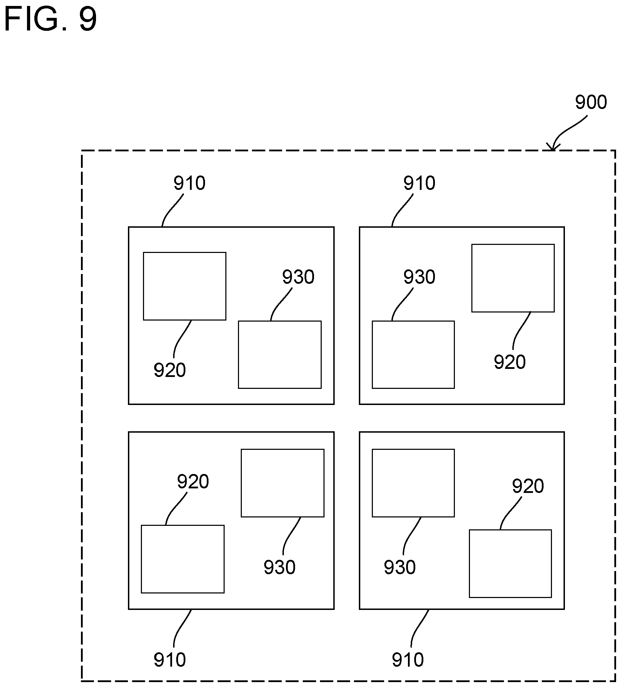

**FIG. 9** illustrates an exemplary device 900 according to some aspects.

In FIG. 9, device 900 includes a plurality of carriers 910.

Each carrier 910 includes a communication processor 920 (disposed on or in carrier 910) configured to provide a wireless communication, and an antenna 930 (disposed on or in carrier 910) coupled to the communication processor 920. The antenna 930 extends into a corner of the carrier 910, and three adjacent carriers 910 are positioned relative to each other so that their respective antennas 930 extending into their respective corners face each other.

The antennas 930 are further positioned such that they are at a "close" distance from each other, in the range at less than about 1 wavelength corresponding to the lowest operating frequency, e.g. 25, 50, 100, 150, 200 or 250 µm from each other for D-band operational bandwidth (110 GHz to 170 GHz).

While the above descriptions and connected figures may depict electronic device components as separate elements, skilled persons will appreciate the various possibilities to combine or integrate discrete elements into a single element. Such may include combining two or more circuits to form a single circuit, mounting two or more circuits onto a common semiconductor chip or chassis to form an integrated element, executing discrete software components on a common processor core, etc. Conversely, skilled persons will recognize the possibility to separate a single element into two or more discrete elements, such as splitting a single circuit into two or more separate circuits, separating a semiconductor chip or chassis into discrete elements originally provided thereon, separating a software component into two or more sections and executing each on a separate processor core, etc.

All acronyms defined in the above description additionally hold in all claims included herein.

The following examples disclose various aspects of this disclosure: Example 1 is a device that may include a plurality of carriers. The plurality of carriers may include a plurality of communication processors, each communication processor disposed over or in a respective carrier of the plurality of carriers and configured to provide a wireless communication channel, and a plurality of antennas, each antenna disposed on or in a respective carrier and coupled to a respective communication processor, wherein each antenna extends into a corner of the respective carrier, wherein for each pair of adjacent carriers, the respective antennas extending into the respective corners face each other, and wherein the antennas of each pair of adjacent carriers are positioned at a distance from each other in the range at less than about 1 wavelength corresponding to the lowest operating frequency.

In Example 2, the subject matter of Example 1 can optionally include that the respective antennas of each pair of adjacent carriers are positioned at a closest (possible) distance from each other.

In Example 3, the subject matter of any one of Examples 1 or 2 can optionally include that the antennas are Extremely-Wideband, EWB, antennas with an operational bandwidth larger than 50 GHz.

In Example 4, the subject matter of any one of Examples 1 to 3 can optionally include that each antenna has an arrow-shaped end portion extending into the corner of the carrier.

In Example 5, the subject matter of Example 4 can optionally include that each antenna has an "archer bow" structure having a co-planar waveguide, CPW, portion and an arrow-shaped end portion, wherein the CPW portion extends from a central portion of the carrier into the arrow-shaped end portion of said carrier.

In Example 6, the subject matter of any one of Examples 1 to 5 can optionally include that each carrier includes an antenna impedance matching structure.

In Example 7, the subject matter of Example 6 can optionally include that the impedance matching structure further includes a plurality of vias extending into the carrier.

In Example 8, the subject matter of Example 7 can optionally include that the plurality of vias includes through vias and blind vias.

In Example 9, the subject matter of Examples 7 or 8 can optionally include that the plurality of vias include glass vias and/or through glass vias.

In Example 10, the subject matter of any one of Examples 1 to 9 can optionally include that each carrier has a multilayer structure.

In Example 11, the subject matter of any one of Examples 1 to 10 can optionally include that each carrier has a multilayer structure comprising a core substrate and at least one structured conductive layer, and that each antenna is formed in the structured conductive layer.

In Example 12, the subject matter of Example 11 can optionally include that the core substrate is a glass core.

In Example 13, the subject matter of any one of Examples 11or 12 can optionally include a further structured conductive layer opposite to the structured conductive layer.

In Example 14, the subject matter of Examples 11 to 13 can optionally include that at least one structured conductive layer is a redistribution layer.

In Example 15, the subject matter of any one of Examples 11 to 14 can optionally include that the structured conductive layers include a metal layer and a substrate layer.

In Example 16, the subject matter of any one of Examples 11 to 15 can optionally include that the substrate layers included in the structured conductive layers are made out of polyimide.

In Example 17, the subject-matter of any one of Examples 11 to 16 can optionally include that each carrier includes at least two upper structured conductive layers, and at least one lower structured conductive layer opposite to the upper structured conductive layers.

In Example 18, the subject-matter of Example 17 can optionally include that each carrier includes a first uppermost structured conductive layer and a second upper structured conductive layer, that each antenna has an arrow-shaped end portion in the second upper structured conductive layer extending into the corner of the carrier, and that at least one lower structured conductive layer has a cutout in a region corresponding to the arrow-shaped end portion of the antenna in the second upper structured conductive layer.

In Example 19, the subject-matter of Examples 17 or 18 can optionally include that each structured conductive layer includes a metal layer and a substrate layer, and that the metal layers including the antenna are electrically grounded through vias.

In Example 20, the subject-matter of Example 19 can optionally include that the vias connecting the metal layers have a convex shape.

In Example 21, the subject-matter of Example 20 can optionally include that the convex-shaped vias are located (situated) near a corner of the carrier.

In Example 22, the subject-matter of any one of Examples 19 to 21 can optionally include that the metal layer of the uppermost structured conductive layer includes a co-planar waveguide, CPW, transmission line, wherein the CPW is used as an antenna feed on the second upper structured conductive layer, and wherein the center signal line of the CPW feed is connected to a via pad, wherein the via pad is connected to a blind glass via.

In Example 23, the subject-matter of Example 22 can optionally include that the center line of the CPW and the second upper structed conductive layer are connected to a void area located (situated) on the metal layer of the second upper structured layer.

In Example 24, the subject-matter of Example 23 can optionally include that the vias connecting the metal layers have a convex shape, that the via pad connecting the driven blind glass via is located (situated) inside of the void area, and that the void area is situated between the convex-shaped vias and a corner of the carrier.

In Example 25, the subject-matter of Example 24 can optionally include that the ground shape of the metal layer in one of the lower structured conductive layers has a cut-out corresponding to the location of the convex-shaped vias (corresponding to the shape formed by the location of the convex-shaped vias).

In Example 26, the subject matter of any one of Examples 1 to 25 can optionally include that the plurality of carriers includes a first plurality of chiplets.

In Example 27, the subject matter of Example 26 can optionally include that the first plurality of chiplets are positioned in a common plane.

In Example 28, the subject matter of Example 27 can optionally include three, or four, or five, or more chiplets, and that the chiplets are positioned such that for each pair of chiplets their respective sides including the antenna face each other.

In Example 29, the subject matter of Example 28 can optionally include that the pairs of chiplets are positioned in a symmetric pattern.

In Example 30, the subject matter of any one of Examples 27 to 29 can optionally include a second plurality of chiplets, wherein each chiplet from the first plurality of chiplets is disposed over a respective chiplet from the second plurality of chiplets to form a plurality of chiplet stacks.

In Example 31, the subject matter of Example 30 can optionally include that the chiplet including the antenna is at the top of each chiplet stack.

In Example 32, the subject matter of any one of Examples 26 to 31 can optionally include a system carrier to carry the plurality of chiplets.

In Example 33, the subject matter of any one of Examples 26 to 32 can optionally include encapsulation material encapsulating all of the chiplets.

In Example 34, the subject matter of any one of Examples 1 to 25 can optionally include that the carriers are Printed Circuit Boards, PCBs or packages.

In Example 35, the subject matter of Example 34 can optionally include that the antenna is formed on a separate antenna chip mounted on the PCB or package.

In Example 36, the subject matter of Example 35 can optionally include that the antenna chip is mounted in a corner of the PCB or package.

In Example 37, the subject matter of Examples 35 or 36 can optionally include that the PCB or package includes a first plurality of chiplets positioned one above the other to form a first chiplet stack, and a second plurality of chiplets positioned one above the other to form a second chiplet stack, wherein the first chiplet stack and the second chiplet stack are located (situated) next to each other, and wherein the chiplet stacks are coupled to the antenna.

In Example 38, the subject matter of any one of Examples 34 to 37 can optionally include that the PCB or package includes an additional RFIC chiplet.

In Example 39, the subject matter of any one of Examples 1 to 38 can optionally include that each communication processor is configured to provide a wireless broadcasting communication channel.

While the invention has been particularly shown and described with reference to specific embodiments, it should be understood by those skilled in the art that various changes in form and detail may be made therein without departing from the spirit and scope of the invention as defined by the appended claims. The scope of the invention is thus indicated by the appended claims and all changes which come within the meaning and range of equivalency of the claims are therefore intended to be embraced.

## Claims

1. A device comprising:
a plurality of carriers;
a plurality of communication processors, each communication processor disposed over or in a respective carrier of the plurality of carriers and configured to provide a wireless communication channel; and
a plurality of antennas, each antenna disposed on or in a respective carrier and coupled to a respective communication processor, wherein each antenna extends into a corner of the respective carrier;
wherein for each pair of adjacent carriers, the respective antennas extending into the respective corners face each other; and
wherein the antennas of each pair of adjacent carriers are positioned at a distance from each other at less than about 1 wavelength corresponding to the lowest operating frequency.

2. The device of claim 1,
wherein the antennas are Extremely-Wideband, EWB, antennas with an operational bandwidth larger than 50 GHz.

3. The device of any one of claims 1 or 2,
wherein each antenna has an arrow-shaped end portion extending into the corner of the carrier.

4. The device of any one of claims 1 to 3,
wherein each carrier comprises an antenna impedance matching structure;
preferably wherein the impedance matching structure further comprises a plurality of vias extending into the carrier.

5. The device of any one of claims 1 to 4,
wherein each carrier has a multilayer structure.

6. The device of any one of claims 1 to 5,
wherein each carrier has a multilayer structure comprising a core substrate and at least one structured conductive layer, and
wherein each antenna is formed in the structured conductive layer;
preferably the device comprising a further structured conductive layer opposite to the structured conductive layer;
further preferably wherein each of the structured conductive layers comprise a metal layer and a substrate layer.

7. The device of claim 6, wherein each carrier comprises:
at least two upper structured conductive layers; and
at least one lower structured conductive layer opposite to the upper structured conductive layers;
preferably wherein each carrier comprises:
a first uppermost structured conductive layer and a second upper structured conductive layer;
wherein each antenna has an arrow-shaped end portion in the second upper structured conductive layer extending into the corner of the carrier, and
wherein the at least one lower structured conductive layer has a cutout in a region corresponding to the arrow-shaped end portion of the antenna in the second upper structured conductive layer.

8. The device of any one of claims 1 to 7,
wherein the plurality of carriers comprises a first plurality of chiplets.

9. The device of claim 8,
wherein the first plurality of chiplets is positioned in a common plane.

10. The device of claim 9, comprising:
three, or four, or five, or more chiplets; and
wherein the chiplets are positioned such that for each pair of chiplets their respective corners comprising the antenna face each other.

11. The device of claim 10, comprising:
a second plurality of chiplets,
wherein each chiplet from the first plurality of chiplets is disposed over a respective chiplet from the second plurality of chiplets to form a plurality of chiplet stacks.

12. The device of any one of claims 1 to 11,
wherein the carriers are Printed Circuit Boards, PCBs.

13. The device of claim 12,
wherein the antenna is formed on a separate antenna chip mounted in a corner of the PCB.

14. The device of claim 13, wherein the PCB further comprises:
a first plurality of chiplets positioned one above the other to form a first chiplet stack; and
a second plurality of chiplets positioned one above the other to form a second chiplet stack;
wherein the first chiplet stack and the second chiplet stack are located next to each other, and
wherein the chiplet stacks are coupled to the antenna; and/or
wherein the PCB includes an additional RFIC chiplet.

15. The device of any one of claims 1 to 14,
wherein each communication processor is configured to provide a wireless broadcasting communication channel.
